# FASCICULE DE BREVET EUROPEEN

(11) **EP 4 142 451 B1**
(45) Date de publication et mention de la délivrance du brevet: **21.02.2024**
(21) Numéro de dépôt: 22190897.3
(22) Date de dépôt: 18.08.2022
(51) Int. Cl.: H10B 63/00, H10N 70/20

(54) **PROCÉDÉ DE FABRICATION DE CELLULES MÉMOIRES RÉSISTIVES**
VERFAHREN ZUR HERSTELLUNG VON RESISTIVEN SPEICHERZELLEN
METHOD FOR MANUFACTURING RESISTIVE MEMORY CELLS

(30) Priorité: 23.08.2021 FR 2108834
(43) Date de publication de la demande: 01.03.2023
(73) Titulaire: Commissariat à l'énergie atomique et aux énergies alternatives, 75015 Paris (FR)
(72) Inventeur: GUILLAUME, Nicolas, 38054 Grenoble Cedex 09 (FR); BLONKOWSKI, Serge, 38054 Grenoble Cedex 09 (FR); CHARPIN-NICOLLE, Christelle, 38054 Grenoble Cedex 09 (FR); JALAGUIER, Eric, 38054 Grenoble Cedex 09 (FR)
(74) Mandataire: INNOV-GROUP

(56) Documents cités:
- US-A1- 2008 237 693
- US-A1- 2011 068 312
- US-A1- 2011 210 303

## Description

### Domaine technique

L'invention se rapporte au domaine technique des mémoires résistives (ReRAM pour « R*esistive* R*andom Access Memory* » en langue anglaise). Les mémoires résistives sont des mémoires non-volatiles, c'est-à-dire capables de conserver une information en l'absence d'alimentation électrique, appartenant à la famille des mémoires à commutation de résistance. Les mémoires résistives sont considérées comme une technologie émergente en raison d'un plus faible degré de maturité que les mémoires non-volatiles conventionnelles, telles que les mémoires Flash.

L'invention trouve notamment son application dans la fabrication de cellules mémoires résistives à base d'oxyde métallique (OxRAM pour « *Oxide Random Access Memory »* en langue anglaise).

### État de l'art

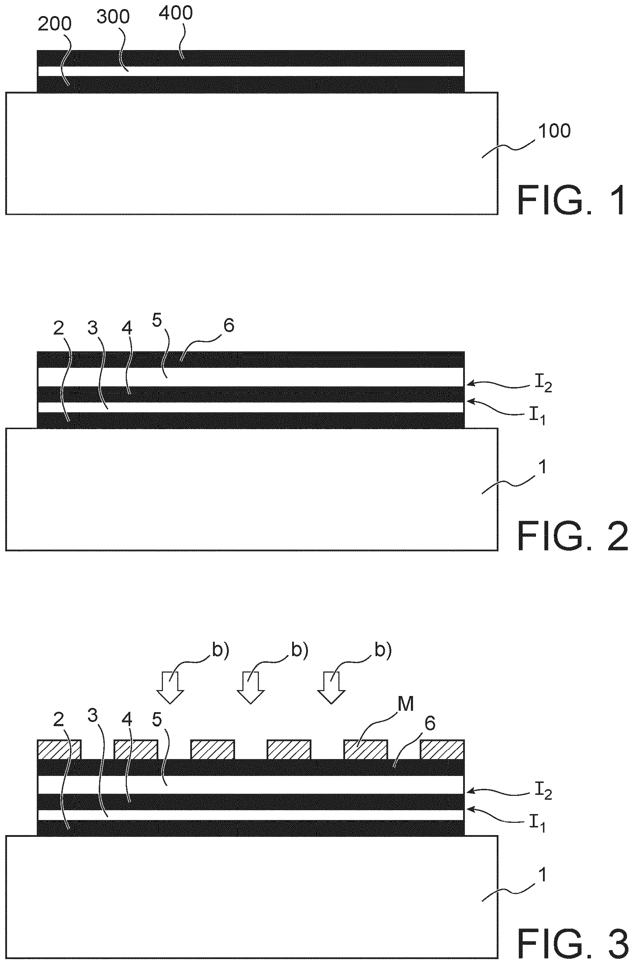

Comme illustré à la figure 1, une cellule mémoire résistive, connue de l'état de la technique, est formée à partir d'un empilement comprenant successivement un substrat 100, une première électrode 200, une couche diélectrique 300, et une deuxième électrode 400. La première électrode 200, la couche diélectrique 300 et la deuxième électrode 400 forment une structure de type Métal-Isolant-Métal (MIM).

Un procédé de fabrication de cellules mémoires résistives, connu de l'état de la technique, comporte une étape initiale d'électro-formation (« *electroforming* » ou « *forming* » en langue anglaise), consistant à appliquer une tension électrique V_{Forming} entre les première et deuxième électrodes de l'empilement, adaptée pour générer un champ électrique supérieur à la rigidité diélectrique de la couche diélectrique. Il en résulte un claquage de la couche diélectrique, s'accompagnant de la formation d'un chemin de conduction électrique au sein de la couche diélectrique, reliant les première et deuxième électrodes.

Le fonctionnement d'une cellule mémoire résistive se traduit par des cycles de réinitialisation (« *Reset»* en langue anglaise) où le chemin de conduction électrique est rompu, et des cycles d'écriture (« *Set»* en langue anglaise) où le chemin de conduction électrique est formé de nouveau. Plus précisément, une cellule mémoire résistive présente un état de haute résistance (H_{RS} pour *« Higb* R*ésistance State*» en langue anglaise) lorsque le chemin de conduction électrique est rompu, et un état de basse résistance (L_{RS} pour « *Low* Re*sistance State*» en langue anglaise) lorsque le chemin de conduction électrique est formé de nouveau. Les cycles de réinitialisation se traduisent par une commutation de l'état L_{RS} vers l'état H_{RS}, caractérisée par l'application d'une tension électrique V_{Reset} entre les première et deuxième électrodes de la cellule mémoire résistive. Les cycles d'écriture se traduisent par une commutation de l'état H_{RS} vers l'état L_{RS}, caractérisée par l'application d'une tension électrique V_{Set} entre les première et deuxième électrodes de la cellule mémoire résistive.

Les commutations entre les états H_{RS} et L_{RS} peuvent avoir une nature unipolaire, bipolaire, ou non-polaire selon la physique de commutation mise en oeuvre et les rôles joués par la couche diélectrique et les première et deuxième électrodes de la cellule mémoire résistive. Plus précisément, les commutations entre les états H_{RS} et L_{RS} ont une nature :
(i) unipolaire lorsque les tensions électriques V_{Set} et V_{Reset} sont d'un seul et unique signe,
(ii) bipolaire lorsque la tension électrique V_{Set} est d'un seul et unique signe, et la tension électrique V_{Reset} est du signe opposé,
(iii) non-polaire lorsque la tension électrique V_{Set} peut être de signe positif ou négatif, et la tension électrique V_{Reset} est du signe opposé.

L'étape d'électro-formation de l'état de la technique n'est pas entièrement satisfaisante dans la mesure où elle implique une tension électrique V_{Forming} élevée (très supérieure à V_{Set}), afin de générer un champ électrique supérieur à la rigidité diélectrique de la couche diélectrique de l'empilement, et ce pour obtenir un claquage de la couche diélectrique. La couche diélectrique est donc fortement sollicitée et le matériau diélectrique risque d'être irrémédiablement endommagé. Or, le claquage de la couche diélectrique doit être réversible afin de reconstruire le chemin de conduction électrique. Pour ce faire, un transistor doit être généralement agencé en série de l'empilement afin de contrôler l'intensité du courant circulant entre les première et deuxième électrodes de l'empilement (intensité typiquement limitée à quelques centaines de µA).

### Exposé de l'invention

L'invention vise à remédier en tout ou partie aux inconvénients précités. A cet effet, l'invention a pour objet un procédé de fabrication de cellules mémoires résistives, comportant les étapes :
a) prévoir un empilement comportant successivement :
   - un substrat, comprenant de préférence des transistors et une structure d'interconnexions ;
   - une première électrode ;
   - une première couche diélectrique, possédant une première rigidité diélectrique;
   - une deuxième électrode, métallique ;
   - une deuxième couche diélectrique, possédant une deuxième rigidité diélectrique strictement inférieure à la première rigidité diélectrique ;
   - une troisième électrode ;
   la première couche diélectrique et la deuxième électrode présentant une première interface, la deuxième couche diélectrique et la deuxième électrode présentant une deuxième interface ;
b) graver l'empilement par un bombardement d'espèces électriquement chargées, de manière à délimiter des cellules mémoires résistives ;
le bombardement de l'étape b) étant adapté de sorte que des espèces électriquement chargées s'accumulent aux première et deuxième interfaces de chaque cellule mémoire résistive, de manière à générer un champ électrique qui est strictement inférieur à la première rigidité diélectrique et strictement supérieur à la deuxième rigidité diélectrique.

### Définitions

- Par « substrat », on entend un support physique autoporté, par exemple une plaquette (« *wafer*» en langue anglaise) découpée dans un lingot monocristallin de matériau semiconducteur.
- Par « structure d'interconnexions », on entend un empilement de niveaux d'interconnexions comprenant des pistes métalliques séparées par un matériau diélectrique. Une structure d'interconnexions peut être formée sur le substrat dans une ligne de fabrication de niveaux d'interconnexions électrique BEOL (« *Back-End-Of-Line* » en langue anglaise, on parle également d'unité de fabrication finale). Les transistors peuvent être intégrés de manière monolithique au substrat dans une ligne de fabrication de dispositifs semi-conducteurs FEOL (« *Front-End-Of-Line* » en langue anglaise, on parle également d'unité de fabrication initiale), en utilisant par exemple des techniques de photolithographie, gravure, diffusion et implantation de dopants, dépôts métalliques, passivation etc.
- Par « rigidité diélectrique », on entend la valeur maximale du champ électrique que la couche diélectrique correspondante peut supporter avant une rupture diélectrique (claquage).
- Par « bombardement adapté », on entend que les paramètres du bombardement (par exemple l'énergie et la dose pour une gravure ionique réactive) sont ajustés pour générer l'intensité souhaitée du champ électrique.

Ainsi, un tel procédé selon l'invention permet de s'affranchir d'une étape d'électro-formation de l'état de la technique, en profitant d'une gravure adaptée de l'empilement (délimitant les cellules mémoires résistives) pour générer un champ électrique permettant d'obtenir le claquage de la deuxième couche diélectrique (dite active). Un tel procédé selon l'invention permet donc de limiter l'intensité du courant électrique (de l'ordre du µA à comparer aux centaines de µA de l'état de la technique) circulant au sein de la deuxième couche diélectrique, via un chemin de conduction électrique obtenu par claquage, si bien qu'il est possible de s'affranchir d'un transistor pour contrôler l'intensité du courant électrique. Ceci est rendu possible grâce à la présence de la première couche diélectrique (dite passive) et de la deuxième électrode métallique, intercalaire, qui permet de piéger les espèces électriquement chargées.

Le champ électrique généré lors de l'étape b) est inférieur à la première rigidité diélectrique afin de ne pas obtenir un claquage de la première couche diélectrique. Un tel claquage serait préjudiciable car les espèces électriquement chargées accumulées aux première et deuxième interfaces pourraient alors s'évacuer vers la première électrode, et empêcheraient par là-même le claquage de la deuxième couche diélectrique et la formation du chemin de conduction électrique en son sein.

Le procédé selon l'invention peut comporter une ou plusieurs des caractéristiques suivantes.

Selon une caractéristique de l'invention, les espèces électriquement chargées s'accumulent lors de l'étape b) aux première et deuxième interfaces de chaque cellule mémoire résistive, selon une densité surfacique de charge adaptée pour générer le champ électrique qui est strictement inférieur à la première rigidité diélectrique et strictement supérieur à la deuxième rigidité diélectrique.

Ainsi, les paramètres du bombardement (par exemple l'énergie et la dose pour une gravure ionique réactive) sont ajustés pour adapter la densité surfacique de charge à l'intensité souhaitée du champ électrique.

Selon une caractéristique de l'invention, la première couche diélectrique de l'empilement prévu lors de l'étape a) présente une épaisseur choisie en fonction du champ électrique généré lors de l'étape b) de manière à autoriser un courant tunnel circulant entre les première et deuxième électrodes.

### Définition

Par « courant tunnel », on entend un courant électrique dont le mécanisme de conduction électrique implique un effet tunnel, c'est-à-dire le mécanisme dit « tunnel direct » ou le mécanisme dit « Fowler-Nordheim » selon la forme de la barrière de potentiel vue par les électrons.

Ainsi, un avantage procuré par de tels régimes de conduction électrique (impliquant une première couche diélectrique ultra-mince) est de réduire fortement la résistance électrique de la première couche diélectrique par rapport à une couche mince, tout en évitant un régime de conduction ohmique. De tels régimes de conduction par effet tunnel permettent de rendre négligeable la résistance électrique de la première couche diélectrique devant la résistance électrique, notée R_{off}, de la deuxième couche diélectrique lorsque la cellule mémoire résistive présente un état de haute résistance H_{RS}. En d'autres termes, de tels régimes de conduction par effet tunnel permettent de limiter fortement la chute de potentiel électrique entre les première et deuxième électrodes lorsque la tension électrique V_{Reset} est appliquée entre les première et troisième électrodes de la cellule mémoire résistive.

Selon une caractéristique de l'invention, le procédé comporte :
- une étape c) consistant à appliquer une première tension électrique, notée V_{Set} entre les première et troisième électrodes de chaque cellule mémoire résistive, adaptée pour former un chemin de conduction électrique au sein de la deuxième couche diélectrique reliant les deuxième et troisième électrodes,
- une étape d) consistant à appliquer une deuxième tension électrique, notée V_{Reset}, entre les première et troisième électrodes de chaque cellule mémoire résistive, adaptée pour rompre le chemin de conduction électrique formé lors de l'étape c) ;

procédé dans lequel la deuxième couche diélectrique de chaque cellule mémoire résistive présente, à l'issue de l'étape d), une résistance électrique notée R_{off}, de préférence comprise entre 10⁴ et 2.10⁵ ohms ;
et la première couche diélectrique de l'empilement prévu lors de l'étape a) est adaptée pour présenter une résistance électrique strictement inférieure à R_{off}, de préférence inférieure ou égale à R_{off}/10.

Ainsi, il a été constaté expérimentalement que les cellules mémoires résistives obtenues à l'issue de l'étape b) ne sont pas directement dans un état de basse résistance L_{RS}. Une telle étape c), exécutée après l'étape b), permet d'imposer l'état de basse résistance L_{RS}.

L'étape d) permet de commuter l'état de basse résistance L_{RS} obtenu lors de l'étape c) vers un état de haute résistance H_{RS}.

Une telle première couche diélectrique permet de limiter fortement la chute de potentiel électrique entre les première et deuxième électrodes lorsque la tension électrique V_{Reset} est appliquée entre les première et troisième électrodes de la cellule mémoire résistive.

Selon une caractéristique de l'invention, l'étape a) est exécutée de sorte que la deuxième couche diélectrique est réalisée dans un oxyde d'hafnium ; et le bombardement de l'étape b) est adapté de sorte que des espèces électriquement chargées s'accumulent aux première et deuxième interfaces de chaque cellule mémoire résistive, selon une densité surfacique de charge comprise entre 10¹³ C par cm² et 5.10¹³ C par cm².

Ainsi, un avantage procuré est de générer un champ électrique de l'ordre de 3 10⁶ V/cm, supérieur à la rigidité diélectrique d'un oxyde d'hafnium, par l'application du théorème de Gauss. Lorsque le claquage se produit au sein de la deuxième couche diélectrique, si l'on considère que le chemin de conduction électrique créé est un filament présentant une section de 1 nm², que les espèces électriquement chargées sont des électrons ayant une vitesse de l'ordre de la vitesse de Fermi (de l'ordre de 10⁵ m/s), le courant électrique circulant entre les deuxième et troisième électrodes est de l'ordre du µA.

Selon une caractéristique de l'invention, l'étape b) est exécutée par une technique de gravure choisie parmi :
- une gravure ionique réactive ;
- une gravure au plasma.

Ainsi, un avantage procuré par de telles techniques de gravure est d'impliquer des espèces électriquement chargées.

Un empilement pour fabriquer des cellules mémoires résistives selon le procédé d'invention, connu par exemple des documents US 2011/068312 A1 et US 2008/237693 A1, comporte successivement :
- un substrat, comprenant de préférence des transistors et une structure d'interconnexions ;
- une première électrode ;
- une première couche diélectrique, possédant une première rigidité diélectrique;
- une deuxième électrode, métallique ;
- une deuxième couche diélectrique, possédant une deuxième rigidité diélectrique strictement inférieure à la première rigidité diélectrique ;
- une troisième électrode.

Par exemple, la deuxième électrode présente une épaisseur comprise entre 5 nm et 100 nm, de préférence comprise entre 5 nm et 40 nm.

Par exemple, la deuxième électrode est réalisée dans au moins un matériau métallique choisi parmi :
- Au, Ag, Pt, Pd, Ir, Rh, Os, Ru, Cu, Re, Hg,
- TiN, TaN.

En particulier, un avantage procuré par Au, Ag, Pt, Pd, Ir, Rh, Os, Ru, Cu, Re, Hg est leur forte résistance à l'oxydation. Cette propriété permet de réduire les risques d'une migration d'ions métalliques vers la première électrode, qui autoriserait potentiellement l'évacuation des espèces électriquement chargées, accumulées aux première et deuxième interfaces, vers la première électrode. Une telle migration d'ions métalliques rendrait donc le claquage de la deuxième couche diélectrique, et par là-même la formation du chemin de conduction électrique en son sein, plus difficile à obtenir.

Par exemple, les première et troisième électrodes sont réalisées dans au moins un matériau choisi parmi Ti, TiN, Pt, Zr, Al, Hf, Ta, TaN, C, Cu, Ag, W.

Par exemple, la première couche diélectrique présente une épaisseur comprise entre 1 nm et 3 nm.

Ainsi, un avantage procuré est d'autoriser un régime de conduction électrique par effet tunnel.

Par exemple, la deuxième couche diélectrique présente une épaisseur comprise entre 4 nm et 15 nm, de préférence comprise entre 5 nm et 10 nm.

Par exemple, la deuxième couche diélectrique est réalisée dans un matériau choisi parmi un oxyde d'hafnium, un oxyde de titane, un oxyde de tantale, un oxyde de nickel, un oxyde de zinc, un oxyde de cuivre, le titanate de zinc, un oxyde de manganèse, un oxyde de magnésium, un oxyde de zirconium, un oxyde de silicium, un nitrure de silicium.

Par exemple,
- la première couche diélectrique est réalisée dans un matériau choisi parmi l'alumine, un nitrure de silicium, un oxyde de silicium ;
- la deuxième couche diélectrique est réalisée dans un oxyde d'hafnium.

Ainsi, un avantage procuré par un matériau choisi parmi l'alumine, un nitrure de silicium, un oxyde de silicium est d'avoir une rigidité diélectrique supérieure à celle d'un oxyde d'hafnium.

Selon une caractéristique de l'invention :
- la première couche diélectrique est réalisée dans un oxyde d'hafnium ;
- la deuxième couche diélectrique peut être réalisée dans un oxyde de titane, par exemple.

Ainsi, un avantage procuré par un oxyde d'hafnium est d'avoir une rigidité diélectrique supérieure à celle d'un oxyde de titane.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 (déjà commentée) est une vue schématique en coupe d'un empilement de l'état de la technique pour fabriquer des cellules mémoires résistives.
Figure 2 est une vue schématique en coupe d'un empilement connu pour fabriquer des cellules mémoires résistives selon l'invention,
Figure 3 est une vue schématique en coupe, illustrant l'étape b) de gravure (symbolisée par les flèches) d'un procédé selon l'invention.
Figure 4 est une vue schématique en coupe, illustrant des cellules mémoires résistives formées par la gravure de l'étape b). L'encart illustre une cellule mémoire résistive à l'échelle agrandie où est visible l'accumulation des espèces électriquement chargées (symbolisées par des ronds) aux première et deuxième interfaces.
Figure 5 est une vue analogue à la figure 4. L'encart illustre la formation d'un chemin de conduction électrique au sein de la deuxième couche diélectrique, à l'issue de l'étape b).

Il est à noter que les dessins décrits ci-avant sont schématiques, et ne sont pas à l'échelle par souci de lisibilité et pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de fabrication de cellules C mémoires résistives, comportant les étapes :
a) prévoir un empilement comportant successivement :
   - un substrat 1, comprenant de préférence des transistors et une structure d'interconnexions (non illustrés) ;
   - une première électrode 2 ;
   - une première couche diélectrique 3, possédant une première rigidité diélectrique;
   - une deuxième électrode 4, métallique ;
   - une deuxième couche diélectrique 5, possédant une deuxième rigidité diélectrique strictement inférieure à la première rigidité diélectrique ;
   - une troisième électrode 6 ;
   la première couche diélectrique 3 et la deuxième électrode 4 présentant une première interface I₁, la deuxième couche diélectrique 5 et la deuxième électrode 4 présentant une deuxième interface I₂ ;
b) graver l'empilement par un bombardement d'espèces électriquement chargées, de manière à délimiter des cellules C mémoires résistives ;
le bombardement de l'étape b) étant adapté de sorte que des espèces électriquement chargées s'accumulent aux première et deuxième interfaces I₁, I₂ de chaque cellule C mémoire résistive, de manière à générer un champ électrique qui est strictement inférieur à la première rigidité diélectrique et strictement supérieur à la deuxième rigidité diélectrique.

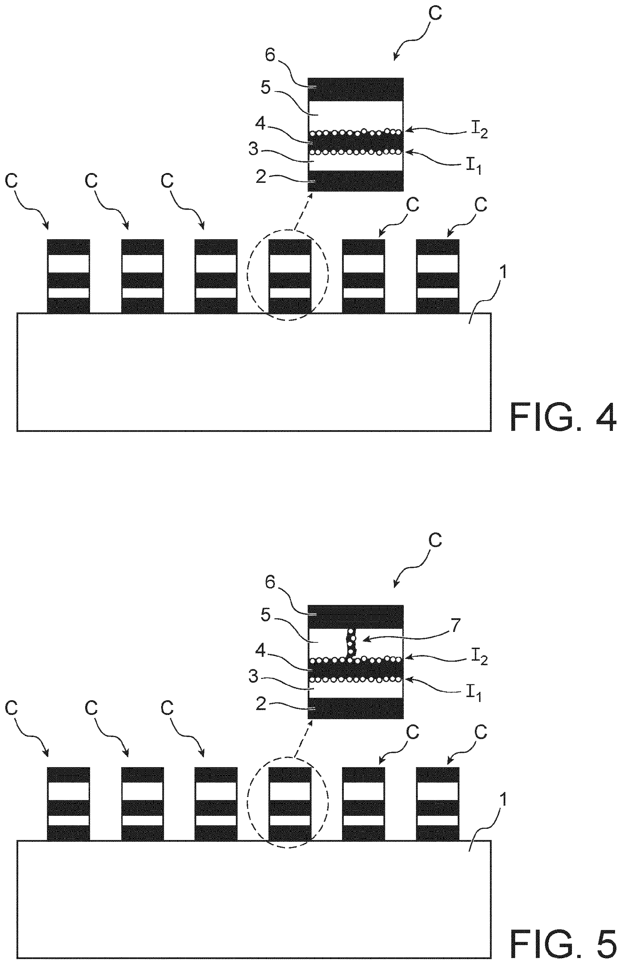

L'empilement prévu lors de l'étape a) est illustré à la figure 2. L'empilement, après l'étape de lithographie et avant l'étape b) de gravure, est illustré à la figure 3. L'accumulation des charges électriquement chargées aux première et deuxième interfaces I₁, I₂ est illustrée à la figure 4. Le claquage de la deuxième couche diélectrique 5 obtenu à l'issue de l'étape b) est illustré à la figure 5.

### Etape a) : substrat

A titre d'exemple non limitatif, l'étape a) peut être exécutée de sorte que le substrat 1 est une plaquette (« *wafer*» en langue anglaise) de silicium.

Le substrat 1 comprend avantageusement des transistors pouvant être intégrés de manière monolithique au substrat 1 dans une ligne de fabrication de dispositifs semi-conducteurs FEOL (« *Front-End-Of-Line* » en langue anglaise, on parle également d'unité de fabrication initiale), en utilisant par exemple des techniques de photolithographie, gravure, diffusion et implantation de dopants, dépôts métalliques, passivation etc.

Le substrat 1 comprend avantageusement une structure d'interconnexions pouvant être formée sur le substrat 1 dans une ligne de fabrication de niveaux d'interconnexions électrique BEOL (« *Back-End-Of-Line* » en langue anglaise, on parle également d'unité de fabrication finale).

La première électrode 2, la première couche diélectrique 3, la deuxième électrode 4, la deuxième couche diélectrique 5 et la troisième électrode 6 s'étendent avantageusement entre deux niveaux d'interconnexions (niveaux métalliques) de la structure d'interconnexions. Les transistors et la structure d'interconnexions peuvent être situés à des niveaux inférieurs par rapport à la première électrode 2, la première couche diélectrique 3, la deuxième électrode 4, la deuxième couche diélectrique 5 et la troisième électrode 6.

### Etape a) : première électrode

L'étape a) est avantageusement exécutée de sorte que la première électrode 2 est réalisée dans au moins un matériau choisi parmi Ti, TiN, Pt, Zr, Al, Hf, Ta, TaN, C, Cu, Ag, W. La première électrode 2 peut être un alliage de ces matériaux.

La première électrode 2 peut présenter une épaisseur supérieure ou égale à 5 nm ou supérieure ou égale à 10 nm.

La première électrode 2 peut être formée sur un trou d'interconnexions (« *via* » en langue anglaise) d'un niveau métallique de la structure d'interconnexions. La première électrode 2 peut être réalisée dans le matériau du trou d'interconnexions ou dans un autre matériau (différent du matériau du trou d'interconnexions) déposé sur le trou d'interconnexions.

### Etape a) : première couche diélectrique

La première couche diélectrique 3 de l'empilement prévu lors de l'étape a) présente avantageusement une épaisseur choisie en fonction du champ électrique généré lors de l'étape b) de manière à autoriser un courant tunnel circulant entre les première et deuxième électrodes 2, 4. L'étape a) est avantageusement exécutée de sorte que la première couche diélectrique 3 présente une épaisseur comprise entre 1 nm et 3 nm, de préférence comprise entre 1 nm et 2 nm.

La première couche diélectrique 3 de l'empilement prévu lors de l'étape a) est avantageusement adaptée pour présenter une résistance électrique strictement inférieure à R_{off}, de préférence inférieure ou égale à R_{off}/10 (cf. section « *Mise en fonctionnement des cellules mémoires résistives* » pour la définition de R_{off}).

### Etape a) : deuxième électrode

L'étape a) est avantageusement exécutée de sorte que la deuxième électrode 4 présente une épaisseur comprise entre 5 nm et 100 nm, de préférence comprise entre 5 nm et 40 nm.

L'étape a) est avantageusement exécutée de sorte que la deuxième électrode 4 est réalisée dans au moins un matériau métallique choisi parmi :
- Au, Ag, Pt, Pd, Ir, Rh, Os, Ru, Cu, Re, Hg,
- TiN, TaN.

La deuxième électrode 4 peut être réalisée dans un alliage électriquement conducteur.

### Etape a) : deuxième couche diélectrique

La deuxième couche diélectrique 5 forme la couche active de la cellule C mémoire résistive. Autrement dit, la deuxième couche diélectrique 5 forme la couche mémoire.

L'étape a) est avantageusement exécutée de sorte que la deuxième couche diélectrique 5 présente une épaisseur comprise entre 4 nm et 15 nm, de préférence comprise entre 5 nm et 10 nm.

L'étape a) est avantageusement exécutée de sorte que la deuxième couche diélectrique 5 est réalisée dans un matériau choisi parmi un oxyde d'hafnium, un oxyde de titane, un oxyde de tantale, un oxyde de nickel, un oxyde de zinc, un oxyde de cuivre, le titanate de zinc, un oxyde de manganèse, un oxyde de magnésium, un oxyde de zirconium, un oxyde de silicium, un nitrure de silicium.

A titre d'exemple non limitatif, lorsque la deuxième couche diélectrique 5 est réalisée dans un oxyde d'hafnium, alors la première couche diélectrique 3 peut être réalisée dans un matériau choisi parmi l'alumine, un nitrure de silicium, un oxyde de silicium.

A titre d'exemple non limitatif, lorsque la deuxième couche diélectrique 5 est réalisée dans un oxyde de titane, alors la première couche diélectrique 3 peut être réalisée dans un oxyde d'hafnium. Dans ce mode de réalisation, l'oxyde d'hafnium est passif et la couche mémoire (active) est réalisée dans un oxyde de titane. L'oxyde d'hafnium possède une rigidité diélectrique supérieure à celle d'un oxyde de titane.

### Etape a) : troisième électrode

L'étape a) est avantageusement exécutée de sorte que la troisième électrode 6 est réalisée dans au moins un matériau choisi parmi Ti, TiN, Pt, Zr, Al, Hf, Ta, TaN, C, Cu, Ag, W. La troisième électrode 6 peut être un alliage de ces matériaux ou un empilement d'une partie de ces matériaux.

La troisième électrode 6 peut présenter une épaisseur supérieure ou égale à 10 nm.

La troisième électrode 6 comporte avantageusement une couche destinée à assurer une fonction de getter pour piéger des atomes d'oxygène. A titre d'exemple non limitatif, la troisième électrode 6 peut être un empilement Ti/TiN ou Ti/TaN, la couche de Ti étant proximale par rapport à la deuxième couche diélectrique 5. La couche de Ti assure une fonction de getter pour piéger les atomes d'oxygène.

### Etape b) de gravure

Comme illustré à la figure 3, l'empilement est recouvert d'un masque M avant l'étape b) de gravure. Le masque M peut être un masque dur ou une résine.

Comme illustré aux figures 4 et 5, les espèces électriquement chargées s'accumulent avantageusement lors de l'étape b) aux première et deuxième interfaces I₁, I₂ de chaque cellule C mémoire résistive, selon une densité surfacique de charge adaptée pour générer le champ électrique qui est strictement inférieur à la première rigidité diélectrique et strictement supérieur à la deuxième rigidité diélectrique.

Lorsque l'étape a) est exécutée de sorte que la deuxième couche diélectrique 5 est réalisée dans un oxyde d'hafnium, le bombardement de l'étape b) est avantageusement adapté de sorte que des espèces électriquement chargées s'accumulent aux première et deuxième interfaces I₁, I₂ de chaque cellule C mémoire résistive, selon une densité surfacique de charge typiquement comprise entre 10¹³ C par cm² et 5. 10¹³ C par cm².

L'étape b) est avantageusement exécutée par une technique de gravure choisie parmi :
- une gravure ionique réactive ;
- une gravure au plasma.

A titre d'exemple non limitatif, lorsque la première électrode 2 est réalisée en TiN, la deuxième électrode 4 est réalisée en TiN, la troisième électrode 6 est réalisée en Ti/TiN, et la deuxième couche diélectrique 5 est réalisée en HfO_{2,} l'étape b) peut utiliser une chimie à base chlorée.

### Mise en fonctionnement des cellules mémoires résistives

Le procédé peut comporter une étape c) consistant à appliquer une première tension électrique, notée V_{Set,} entre les première et troisième électrodes 2, 6 de chaque cellule C mémoire résistive, adaptée pour former un chemin de conduction 7 électrique (visible à la figure 5) au sein de la deuxième couche diélectrique 5 reliant les deuxième et troisième électrodes 4, 6. A titre d'exemple, V_{Set} peut être compris entre 1 V et 3 V.

Le procédé peut comporter une étape d) consistant à appliquer une deuxième tension électrique, notée V_{Reset}, entre les première et troisième électrodes 2, 6 de chaque cellule C mémoire résistive, adaptée pour rompre le chemin de conduction 7 électrique formé lors de l'étape c). La deuxième couche diélectrique 5 de chaque cellule C mémoire résistive présente, à l'issue de l'étape d), une résistance électrique notée R_{off}, de préférence comprise entre 10⁴ et 2. 10⁵ ohms. A titre d'exemple, V_{Reset} peut être compris entre -1 V et -3 V.

La deuxième électrode 4 de chaque cellule C mémoire résistive est une électrode à potentiel flottant, c'est-à-dire que la deuxième électrode 4 n'est pas soumise à un potentiel électrique de référence au cours du fonctionnement de la cellule C mémoire résistive.

### Empilement

Un empilement pour fabriquer des cellules C mémoires résistives comporte successivement:
- un substrat 1, comprenant de préférence des transistors et une couche d'interconnexions ;
- une première électrode 2 ;
- une première couche diélectrique 3, possédant une première rigidité diélectrique;
- une deuxième électrode 4, métallique ;
- une deuxième couche diélectrique 5, possédant une deuxième rigidité diélectrique strictement inférieure à la première rigidité diélectrique ;
- une troisième électrode 6.

Les caractéristiques techniques décrites ci-avant pour le procédé (le substrat 1 ; les première, deuxième, et troisième électrodes 2, 4, 6 ; les première et deuxième couches diélectriques 3, 5) s'appliquent également pour cet object.

L'invention ne se limite pas aux modes de réalisation exposés. L'homme du métier est mis à même de considérer leurs combinaisons techniquement opérantes, et de leur substituer des équivalents dans le cadre des revendications ci-jointes.

## Revendications

1. Procédé de fabrication de cellules (C) mémoires résistives, comportant les étapes :
a) prévoir un empilement comportant successivement :
- un substrat (1), comprenant de préférence des transistors et une structure d'interconnexions ;
- une première électrode (2) ;
- une première couche diélectrique (3), possédant une première rigidité diélectrique;
- une deuxième électrode (4), métallique ;
- une deuxième couche diélectrique (5), possédant une deuxième rigidité diélectrique strictement inférieure à la première rigidité diélectrique ;
- une troisième électrode (6) ;
la première couche diélectrique (3) et la deuxième électrode (4) présentant une première interface (I₁), la deuxième couche diélectrique (5) et la deuxième électrode (4) présentant une deuxième interface (I₂) ;
b) graver l'empilement par un bombardement d'espèces électriquement chargées, de manière à délimiter des cellules (C) mémoires résistives ;
**caractérisé en ce que** le bombardement de l'étape b) est adapté de sorte que des espèces électriquement chargées s'accumulent aux première et deuxième interfaces (I₁, I₂) de chaque cellule (C) mémoire résistive, de manière à générer un champ électrique qui est strictement inférieur à la première rigidité diélectrique et strictement supérieur à la deuxième rigidité diélectrique.

2. Procédé selon la revendication 1, dans lequel les espèces électriquement chargées s'accumulent lors de l'étape b) aux première et deuxième interfaces (I₁, I₂) de chaque cellule (C) mémoire résistive, selon une densité surfacique de charge adaptée pour générer le champ électrique qui est strictement inférieur à la première rigidité diélectrique et strictement supérieur à la deuxième rigidité diélectrique.

3. Procédé selon la revendication 1 ou 2, dans lequel la première couche diélectrique (3) de l'empilement prévu lors de l'étape a) présente une épaisseur choisie en fonction du champ électrique généré lors de l'étape b) de manière à autoriser un courant tunnel circulant entre les première et deuxième électrodes (2, 4).

4. Procédé selon l'une des revendications 1 à 3, comportant :
- une étape c) consistant à appliquer une première tension électrique, notée V_{Set,} entre les première et troisième électrodes (2, 6) de chaque cellule (C) mémoire résistive, adaptée pour former un chemin de conduction (7) électrique au sein de la deuxième couche diélectrique (5) reliant les deuxième et troisième électrodes (4, 6) ;
- une étape d) consistant à appliquer une deuxième tension électrique, notée V_{Reset}, entre les première et troisième électrodes (2, 6) de chaque cellule (C) mémoire résistive, adaptée pour rompre le chemin de conduction (7) électrique formé lors de l'étape c) ;
procédé dans lequel la deuxième couche diélectrique (5) de chaque cellule (C) mémoire résistive présente, à l'issue de l'étape d), une résistance électrique notée R_{off}, de préférence comprise entre 10⁴ et 2.10⁵ ohms ;
et dans lequel la première couche diélectrique (3) de l'empilement prévu lors de l'étape a) est adaptée pour présenter une résistance électrique strictement inférieure à R_{off}, de préférence inférieure ou égale à R_{off}/10.

5. Procédé selon l'une des revendications 1 à 4, dans lequel l'étape a) est exécutée de sorte que la deuxième couche diélectrique (5) est réalisée dans un oxyde d'hafnium ; et le bombardement de l'étape b) est adapté de sorte que des espèces électriquement chargées s'accumulent aux première et deuxième interfaces (I₁, I₂) de chaque cellule (C) mémoire résistive, selon une densité surfacique de charge comprise entre 10¹³ C par cm² et 5.10¹³ C par cm².

6. Procédé selon l'une des revendications 1 à 5, dans lequel l'étape b) est exécutée par une technique de gravure choisie parmi :
- une gravure ionique réactive ;
- une gravure au plasma.

## Patentansprüche

1. Verfahren zur Herstellung von resistiven Speicherzellen (C), umfassend die Schritte:
a) Bereitstellen eines Stapels, der aufeinander folgend umfasst:
- ein Substrat (1), das bevorzugt Transistoren und eine Kontaktierungsstruktur beinhaltet;
- eine erste Elektrode (2);
- eine erste dielektrische Schicht (3), die eine erste Durchschlagfestigkeit besitzt;
- eine zweite, metallische, Elektrode (4);
- eine zweite dielektrische Schicht (5), die eine zweite Durchschlagfestigkeit besitzt, die kleiner als die erste Durchschlagfestigkeit ist;
- eine dritte Elektrode (6);
wobei die erste dielektrische Schicht (3) und die zweite Elektrode (4) eine erste Grenzfläche (I₁) aufweisen, wobei die zweite dielektrische Schicht (5) und die zweite Elektrode (4) eine zweite Grenzfläche (I₂) aufweisen;
b) Ätzen des Stapels durch ein Bombardement mit elektrisch geladenen Spezies, so dass resistive Speicherzellen (C) begrenzt werden;
**dadurch gekennzeichnet, dass** das Bombardement des Schritts b) so angepasst ist, dass sich elektrisch geladene Spezies an den ersten und zweiten Grenzflächen (I₁, I₂) jeder resistiven Speicherzelle (C) sammeln, so dass ein elektrisches Feld erzeugt wird, das kleiner als die erste Durchschlagfestigkeit und größer als die zweite Durchschlagfestigkeit ist.

2. Verfahren nach Anspruch 1, bei dem sich die elektrisch geladenen Spezies beim Schritt b) an den ersten und zweiten Grenzflächen (I₁, I₂) jeder resistiven Speicherzelle (C) gemäß einer Oberflächenladungsdichte sammeln, die angepasst ist, um das elektrische Feld zu erzeugen, das kleiner als die erste Durchschlagfestigkeit und größer als die zweite Durchschlagfestigkeit ist.

3. Verfahren nach Anspruch 1 oder 2, bei dem die erste dielektrische Schicht (3) des beim Schritt a) bereitgestellten Stapels eine Dicke aufweist, die in Abhängigkeit von dem beim Schritt b) erzeugten elektrischen Feld so gewählt wird, dass ein Tunnelstrom zugelassen wird, der zwischen den ersten und zweiten Elektroden (2, 4) fließt.

4. Verfahren nach einem der Ansprüche 1 bis 3, umfassend:
- einen Schritt c), der darin besteht, eine erste elektrische Spannung, bezeichnet als V_{Set}, zwischen den ersten und dritten Elektroden (2, 6) jeder resistiven Speicherzelle (C) anzulegen, die angepasst ist, um einen elektrisch leitenden Pfad (7) in der zweiten dielektrischen Schicht (5) zu bilden, die die zweiten und dritten Elektroden (4, 6) verbindet;
- einen Schritt d), der darin besteht, eine zweite elektrische Spannung, bezeichnet als V_{Reset}, zwischen den ersten und dritten Elektroden (2, 6) jeder resistiven Speicherzelle (C) anzulegen, die angepasst ist, um den beim Schritt c) gebildeten elektrisch leitenden Pfad (7) zu unterbrechen;
Verfahren, bei dem die zweite dielektrische Schicht (5) jeder resistiven Speicherzelle (C) nach dem Schritt d) einen elektrischen Widerstand, bezeichnet als R_{off}, aufweist, der bevorzugt zwischen 10⁴ und 2.10⁵ Ohm beträgt;
und bei dem die erste dielektrische Schicht (3) des beim Schritt a) bereitgestellten Stapels angepasst ist, um einen elektrischen Widerstand aufzuweisen, der kleiner als R_{off} ist, bevorzugt kleiner als oder gleich R_{off}/10.

5. Verfahren nach einem der Ansprüche 1 bis 4, bei dem der Schritt a) so durchgeführt wird, dass die zweite dielektrische Schicht (5) aus einem Hafniumoxid ausgeführt ist; und das Bombardement des Schritts b) so angepasst ist, das sich elektrisch geladene Spezies an den ersten und zweiten Grenzflächen (I₁, I₂) jeder resistiven Speicherzelle (C) gemäß einer Oberflächenladungsdichte zwischen 10¹³ C je cm² und 5.10¹³ C je cm² sammeln.

6. Verfahren nach einem der Ansprüche 1 bis 5, bei dem der Schritt b) mit einer Ätztechnik durchgeführt wird, die gewählt ist unter:
- einem reaktiven lonenätzen;
- einem Plasmaätzen.

## Claims

1. Method for manufacturing resistive memory cells (C), comprising the following steps:
a) providing a stack successively comprising:
- a substrate (1), preferably comprising transistors and an interconnection structure;
- a first electrode (2);
- a first dielectric layer (3), having a first dielectric strength;
- a second metal electrode (4);
- a second dielectric layer (5), having a second dielectric strength that is strictly less than the first dielectric strength;
- a third electrode (6);
the first dielectric layer (3) and the second electrode (4) having a first interface (I₁), the second dielectric layer (5) and the second electrode (4) having a second interface (12);
b) etching the stack by bombardment with electrically charged species, so as to define resistive memory cells (C);
**characterized in that** the bombardment of step b) is adapted so that electrically charged species accumulate at the first and second interfaces (I₁, I₂) of each resistive memory cell (C), so as to generate an electric field that is strictly less than the first dielectric strength and is strictly greater than the second dielectric strength.

2. Method according to Claim 1, wherein the electrically charged species accumulate in step b) at the first and second interfaces (I₁, I₂) of each resistive memory cell (C), according to a surface charge density adapted to generate the electric field that is strictly less than the first dielectric strength and is strictly greater than the second dielectric strength.

3. Method according to Claim 1 or 2, wherein the thickness of the first dielectric layer (3) of the stack provided in step a) is selected as a function of the electric field generated in step b) so as to allow a tunnel current circulating between the first and second electrodes (2, 4).

4. Method according to any of Claims 1 to 3, comprising:
- a step c) consisting in applying a first electric voltage, denoted Vset, between the first and third electrodes (2, 6) of each resistive memory cell (C), adapted to form an electrical conduction path (7) within the second dielectric layer (5) connecting the second and third electrodes (4, 6);
- a step d) consisting in applying a second electric voltage, denoted V_{Reset}, between the first and third electrodes (2, 6) of each resistive memory cell (C), adapted to break the electrical conduction path (7) formed in step c);
in which method the second dielectric layer (5) of each resistive memory cell (C) has, on completion of step d), an electrical resistance denoted R_{off}, preferably ranging between 10⁴ and 2.10⁵ ohms;
and in which the first dielectric layer (3) of the stack provided in step a) is adapted to have an electrical resistance that is strictly less than R_{off}, preferably less than or equal to R_{off}/10.

5. Method according to any of Claims 1 to 4, wherein step a) is performed so that the second dielectric layer (5) is made of a hafnium oxide, and the bombardment of step b) is adapted so that electrically charged species accumulate at the first and second interfaces (I₁, I₂) of each resistive memory cell (C), according to a surface charge density ranging between 10¹³ C per cm² and 5.10¹³ C per cm².

6. Method according to any of Claims 1 to 5, wherein step b) is performed using an etching technique selected from among:
- reactive ion etching;
- plasma etching.
